# EUROPEAN PATENT APPLICATION

(11) **EP 2 333 855 A1**
(43) Date of publication of application: **15.06.2011**
(21) Application number: 09290932.4
(22) Date of filing: 11.12.2009
(51) Int. Cl.: H01L 35/32, H05K 7/20

(54) **Energy recuperation for outside plant deployments**

(71) Applicant: Alcatel Lucent, 75008 Paris (FR)
(72) Inventor: Content, Jurgen, 8370 Blankenberge (BE); Pintelton, Johan, 9420 De Haan (BE)
(74) Representative: Narmon, Gisèle Marie Thérèse

(57) **Abstract**

An outside plant cabinet such as a telecommunication street cabinet housing telecommunication equipment dissipating heat, and of which at least one lateral wall is provided with series connected thermo-electric recuperation cells (ThR) operating according the Seebeck effect. The wall comprises an internal side (WI), an external side (WE) and, in a preferred embodiment, an intermediate side (WM), which all are heat conducting. The sides are in thermal contact with the thermo-electric recuperation cells, which generate electricity (VOUT-/+) derived from the temperature difference between these walls. The recuperated energy can be used to feed the internal equipment.

## Description

In the telecommunication access equipment there is currently a change in deployment model. Where telco's used to deploy out of big Central Office buildings, more and more deployments are done from remote places, i.e. outside plant cabinets (street cabinets, basements, etc.), in order to increase bandwidth to the end user.

In these remote deployment conditions a couple of constraints exist and relate to power consumption, heat dissipation, space and, specifically for Europe, the Code of Conduct which will become mandatory in a few years.

The present invention relates to an outside plant cabinet housing telecommunication equipment dissipating heat.

Such an outside plant cabinet is generally known in the art and a problem therewith is the cooling of the telecommunication equipment dissipating heat.

An outside plant cabinet needs to be as small as possible for a given number of subscriber lines. The termination of, e.g., VDSL lines as telecommunication equipment consumes a lot of energy, whereof the main part is just converted into heat which is typically extracted by fans through filters, heat exchangers or even air conditioners. In any case, most of the known solutions only transport the heat from inside the cabinet into the environment.

These known solutions only care about cooling and ventilating and as such wasting power consumed by the active equipment.

An object of the present invention is to provide an outside plant cabinet of the above known type but wherein energy is recuperated while remaining environmental friendly.

According to the invention, this object is achieved due to the fact that at least one wall of the cabinet is provided with thermo-electric recuperation cells.

Although thermoelectric generators have been known for a long time, the use of thermo-electric recuperation cells on one or more walls of an outside plant cabinet is new and inventive in that it allows recuperating energy whereby less power is drawn from the telecommunication equipment.

Another characterizing embodiment of the present invention is that said thermo-electric recuperation cells are adapted to operate according the Seebeck effect.

The Seebeck effect, also known as reverse Peltier effect, is a conversion of heat differences appearing at opposite flanks or sides of the wall of the cabinet into electricity.

Also another characterizing embodiment of the present invention is that a plurality of electrically coupled thermo-electric recuperation cells is located between and in thermal contact with an internal side and an external side of said wall.

In this way, the temperature difference between the relatively cold external side of the wall of the outside plant cabinet and the hot internal side thereof receiving heat generated by the telecommunication equipment is transformed into electricity owing to the thermo-electric recuperation cells.

In is to be noted that solar panels could also be used for recuperating energy and generating electricity therefrom. However, solar panels have to be placed outside the cabinet and may thereby suffer from vandalism. This is not the case with the present thermo-electric recuperation cells which are protected by the external side of the wall of the outside plant cabinet.

Yet another characterizing embodiment of the present invention is that the thermo-electric recuperation cells of said plurality are electrically coupled in series.

The series coupling of the thermo-electric recuperation cells allows increasing the output voltage resulting from the recuperated energy.

In a variant characterizing embodiment of the present invention, said wall comprises an internal side, an external side and an intermediate side located between said internal side and said external side, a first plurality of electrically coupled thermo-electric recuperation cells is located between and in thermal contact with said internal side and said intermediate side, a second plurality of electrically coupled thermo-electric recuperation cells is located between and in thermal contact with said external side and said intermediate side, and said first and second plurality of thermo-electric recuperation cells are electrically interconnected and each have an electrical output terminal.

Owing to the additional intermediate side, the two pluralities or arrays of thermo-electric recuperation cells allows recuperating even more energy.

In a preferred characterizing embodiment of the present invention, said wall is a lateral wall of said outside plant cabinet.

One or more lateral walls of the outside plant cabinet are preferred to house the thermo-electric recuperation cells rather than the top or roof wall of which the external side may become too hot because of the external temperature above the cabinet and the effect of the sun.

Further characterizing embodiments of the present outside plant cabinet are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:
Fig. 1 shows a thermo-electric recuperation cell located between sides of a wall of an outside plant cabinet according to the invention;
Fig. 2 shows an array of series electrically connected thermo-electric recuperation cells as shown at Fig. 1; and
Fig. 3 shows a variant embodiment of Fig. 2 with two interconnected arrays of thermo-electric recuperation cells.

The present invention relates to an outside plant cabinet, which may be a telecommunication street cabinet, a basement, etc, whereof one or more walls are provided with thermo-electric recuperation cells.

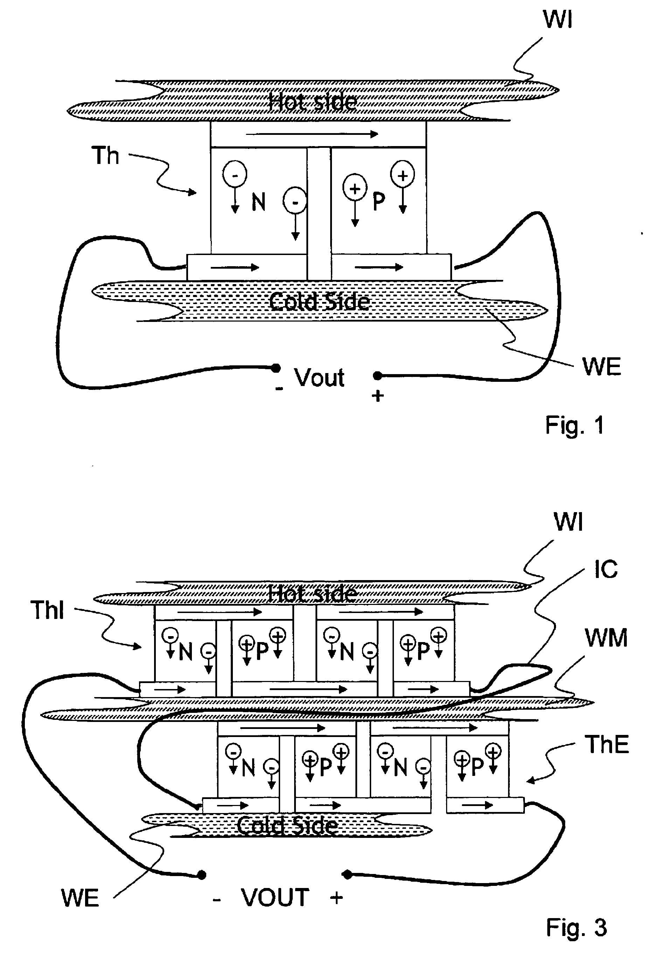

An example of a thermo-electric recuperation cell Th is shown at Fig. 1. The thermo-electric recuperation cell Th is located between an internal side WI and an external side WE of the wall. The sides are heat-conducting and in thermal contact with the thermo-electric recuperation cell Th.

The internal side or hot side WI is the internal part of the wall towards the inside of the cabinet and collects the heat dissipated by the telecommunication equipment housed in this cabinet, whilst the external side or cold side WE is the external part of the wall towards the outside.

A thermo-electric recuperation cell Th operates according the Seebeck effect, also known as reverse Peltier effect, which allows converting differences in temperature into an electric current.

The thermo-electric recuperation cell Th is constituted by two electrically coupled elements of metals or semiconductors, a negative element N and a positive P that are connected to each other at two junctions, called Peltier junctions. Both the negative element N and the positive element P are in thermal contact with the internal side WI and with the external side WE of the wall.

The difference of temperature between the relatively cold external side WE and the relatively hot internal side WI is captured by the thermo-electric recuperation cell Th which transforms this energy into electricity. As a result, the thermo-electric recuperation cell Th provides a negative output voltage Vout- at a terminal of the negative element N and a positive output voltage Vout+ at a terminal of the positive element P.

This electrical energy provided by the thermo-electric recuperation cell Th can be fed back into power inlets of the active equipment so that a part of energy needs is coming from recuperated dissipated energy. The energy consumption drawn from the electricity network can thereby be lowered. As a result, apart from environmental friendliness, there is also a gain in OPEX for the telco.

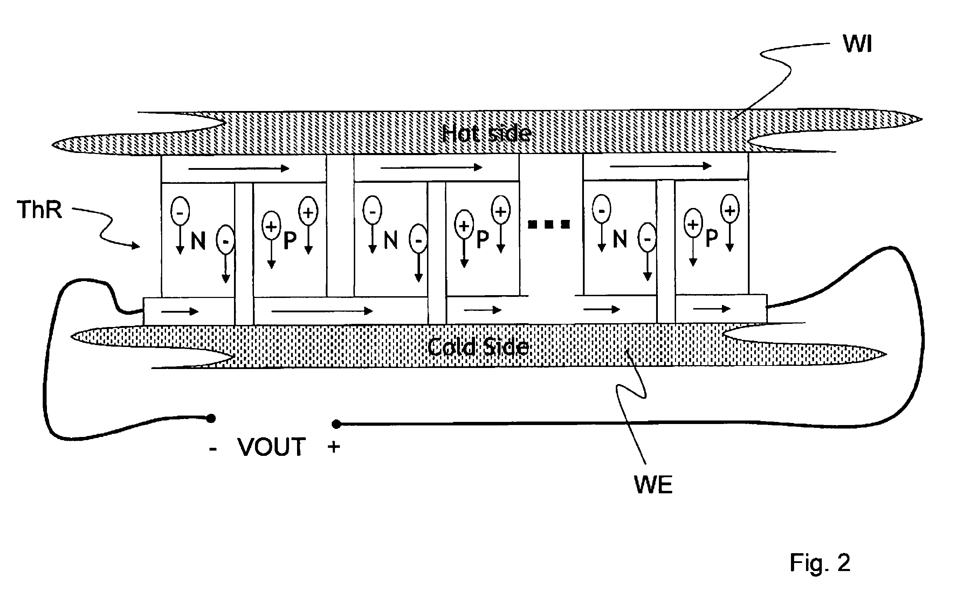

However, one single thermo-electric recuperation cell Th may not be enough for providing sufficient energy for feeding equipment. Therefore, a plurality of thermo-electric recuperation cells ThR, as shown at Fig. 2 is preferably provided. All the cells of the plurality ThR are similar to the single thermo-electric recuperation cell Th and are series connected. The negative element N of a cell is connected to the positive element P of its neighboring cell.

This series connection of cells increases the voltage at the output terminals VOUT- and VOUT+ at the ends of the plurality, whereby the energy provided is also higher than with a single cell.

It is to be noted that the cells of the plurality could also be connected in parallel. This will increase the output current rather the output voltage. A combination of series and parallel connections can also be designed.

In order to increase even more the output energy at VOUT-/+, the number of thermo-electric recuperation cells associated to the wall may doubled by providing an intermediate side WM between the internal side WI and the external side WE, as shown at Fig. 3.

In this preferred embodiment, a first plurality of electrically coupled thermo-electric recuperation cells ThI is located between and in thermal contact with the internal side WI and the intermediate side WM, whilst a second plurality of electrically coupled thermo-electric recuperation cells ThE is located between and in thermal contact with the external side WE and the intermediate side WM. The first ThI and second ThE pluralities of thermo-electric recuperation cells are electrically interconnected, e.g. via a cable IC linking one end of each of these pluralities. The other end of the series connected thermo-electric recuperation cells ThI is connected to an electrical output terminal VOUT-, whilst the other end of the series connected thermo-electric recuperation cells ThE is connected to an electrical output terminal VOUT+.

It is to be noted that the (one or more) wall associated to or housing the thermo-electric recuperation cells is preferably a lateral wall of the outside plant cabinet rather than the door area or even roof area. The top or roof wall or area is not preferred because of solar loading.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. An outside plant cabinet housing telecommunication equipment dissipating heat, ***characterized in that*** at least one wall of the cabinet is provided with thermo-electric recuperation cells (ThR).

2. The cabinet according to claim **1, *characterized in that*** said thermo-electric recuperation cells (Th; ThR) are adapted to operate according the Seebeck effect.

3. The cabinet according to claim 1, ***characterized in that*** a plurality of electrically coupled thermo-electric recuperation cells is located between and in thermal contact with an internal side (WI) and an external side (WE) of said wall.

4. The cabinet according to claim 3,
***characterized in that*** each thermo-electric recuperation cell (Th) of said plurality (ThR) comprises a negative element (N) electrically coupled to a positive element (P),
***in that*** both said negative element and said positive element are in thermal contact with said internal side (WI) and with said external side (WE) of said wall,
***and in that*** said thermo-electric recuperation cell is adapted to provide a negative output voltage (Vout-) at a terminal of said negative element and a positive output voltage (Vout+) at a terminal of said positive element.

5. The cabinet according to claim 4, ***characterized in* that** the thermo-electric recuperation cells (Th) of said plurality are electrically coupled in series, a negative element (N) of a first cell of said plurality being connected to a positive element (P) of a next cell of said plurality.

6. The cabinet according to claim 1,
***characterized in that*** said wall comprises an internal side (WI), an external side (WE) and an intermediate side (WM) located between said internal side and said external side,
***in that*** a first plurality of electrically coupled thermo-electric recuperation cells (ThI) is located between and in thermal contact with said internal side and said intermediate side,
***in that*** a second plurality of electrically coupled thermo-electric recuperation cells (ThE) is located between and in thermal contact with said external side and said intermediate side,
***and in that*** said first and second plurality of thermo-electric recuperation cells are electrically interconnected (IC) and each have an electrical output terminal (VOUT- ; VOUT+).

7. The cabinet according to claim **1, *characterized in that*** said outside plant cabinet is a telecommunication street cabinet.

8. The cabinet according to any of the claims 3 or 6, ***characterized in that*** said wall is a lateral wall of said outside plant cabinet.

9. The cabinet according to any of the preceding claims, ***characterized in that*** said sides are heat-conducting.

## Amended claims

### Amended claims in accordance with Rule 137(2) EPC.

**1.** An outside plant cabinet housing telecommunication equipment dissipating heat, ***characterized in that*** at least one wall of the cabinet is provided with thermo-electric recuperation cells (ThR).

**2.** The cabinet according to claim **1**, ***characterized in that*** a plurality of electrically coupled thermo-electric recuperation cells, each operating according the Seebeck effect, is located between and is in thermal contact with an internal side (WI) and an external side (WE) of said wall.

**3.** The cabinet according to claim **2**,
***characterized in that*** each thermo-electric recuperation cell (Th) of said plurality (ThR) comprises a negative element (N) electrically coupled to a positive element (P),
***in that*** both said negative element and said positive element are in thermal contact with said internal side (WI) and with said external side (WE) of said wall,
*and **in that*** said thermo-electric recuperation cell is adapted to provide a negative output voltage (Vout-) at a terminal of said negative element and a positive output voltage (Vout+) at a terminal of said positive element.

**4.** The cabinet according to claim **3**, ***characterized in that*** the thermo-electric recuperation cells (Th) of said plurality are electrically coupled in series, a negative element (N) of a first cell of said plurality being connected to a positive element (P) of a next cell of said plurality.

**5.** The cabinet according to claim **1**,
***characterized in that*** said wall comprises an internal side (WI), an external side (WE) and an intermediate side (WM) located between said internal side and said external side,
***in that*** a first plurality of electrically coupled thermo-electric recuperation cells (Thl) is located between and in thermal contact with said internal side and said intermediate side,
***in that*** a second plurality of electrically coupled thermo-electric recuperation cells (ThE) is located between and in thermal contact with said external side and said intermediate side,
*and **in that*** said first and second plurality of thermo-electric recuperation cells are electrically interconnected (IC) and each have an electrical output terminal (VOUT- ; VOUT+).

**6.** The cabinet according to claim **1**, ***characterized in that*** said outside plant cabinet is a telecommunication street cabinet.

**7.** The cabinet according to any of the claims **2** or **5**, ***characterized in that*** said wall is a lateral wall of said outside plant cabinet.

**8.** The cabinet according to any of the preceding claims, ***characterized in that*** said sides are heat-conducting.
